(19) Europäisches Patentamt
European Patent Office
Office européen des brevets

(11) **EP 3 238 094 B1**

(12) **FASCICULE DE BREVET EUROPEEN**

(45) Date de publication et mention
de la délivrance du brevet:
**23.07.2025 Bulletin 2025/30**

(21) Numéro de dépôt: **15820534.4**

(22) Date de dépôt: **23.12.2015**

(51) Classification Internationale des Brevets (IPC):
**G06F 17/18** (2006.01)    **G01S 3/74** (2006.01)
**G06F 18/2134** (2023.01)    **G06F 18/2321** (2023.01)

(52) Classification Coopérative des Brevets (CPC):
**G06F 17/18; G06F 18/21345; G06F 18/2321;**
G01S 3/74

(86) Numéro de dépôt international:
**PCT/EP2015/081213**

(87) Numéro de publication internationale:
**WO 2016/102697 (30.06.2016 Gazette 2016/26)**

(54) **PROCÉDÉ NON LINÉAIRE D'ESTIMATION D'UN MÉLANGE DE SIGNAUX**

VERFAHREN ZUR NICHTLINEAREN SCHÄTZUNG EINES SIGNALGEMISCHES

METHOD FOR THE NON-LINEAR ESTIMATION OF A MIXTURE OF SIGNALS

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **23.12.2014 FR 1402981**

(43) Date de publication de la demande:
**01.11.2017 Bulletin 2017/44**

(73) Titulaire: **THALES**
**92400 Courbevoie (FR)**

(72) Inventeurs:
• **LE MEUR, Anne**
**78851 Elancourt (FR)**
• **DELABBAYE, Jean-Yves**
**78851 Elancourt (FR)**

(74) Mandataire: **Lavoix**
**2, place d'Estienne d'Orves**
**75441 Paris Cedex 09 (FR)**

(56) Documents cités:
• **MASTER A S: "Bayesian two source modeling
for separation of n sources from stereo signals",
ACOUSTICS, SPEECH, AND SIGNAL
PROCESSING, 2004. PROCEEDINGS. (ICASSP '
04). IEEE INTERNATIONAL CONFERENCE ON
MONTREAL, QUEBEC, CANADA 17-21 MAY
2004, PISCATAWAY, NJ, USA,IEEE, PISCATAWAY,
NJ, USA, vol. 4, 17 May 2004 (2004-05-17), pages
281 - 284, XP010718460, ISBN:
978-0-7803-8484-2, DOI: 10.1109/
ICASSP.2004.1326818**
• **CARLOS E ET AL: "ICA BASED BLIND SOURCE
SEPARATION APPLIED TO RADIO
SURVEILLANCE", IEICE TRANSACTIONS ON
COMMUNICATIONS, COMMUNICATIONS
SOCIETY, TOKYO, JP, vol. E86-B, no. 12,
December 2003 (2003-12-01), pages 3491 - 3497,
XP001191555, ISSN: 0916-8516**
• **C. FEVOTTE ET AL: "A Bayesian Approach for
Blind Separation of Sparse Sources", IEEE
TRANSACTIONS ON AUDIO, SPEECH AND
LANGUAGE PROCESSING, vol. 14, no. 6,
November 2006 (2006-11-01), New York, NY,
USA., pages 2174 - 2188, XP055224805, ISSN:
1558-7916, DOI: 10.1109/TSA.2005.858523**

• ZAYYANI H ET AL: "Estimating the mixing matrix in Sparse Component Analysis (SCA) using EM algorithm and iterative Bayesian clustering", 2006 14TH EUROPEAN SIGNAL PROCESSING CONFERENCE, IEEE, 25 August 2008 (2008-08-25), pages 1 - 5, XP032761251, ISSN: 2219-5491, [retrieved on 20150403]

**EP 3 238 094 B1**

## Description

La présente invention concerne un procédé d'estimation des signaux radioélectriques provenant de plusieurs sources, dont la représentation en temps/fréquence fait apparaître une proportion non nulle inconnue de composantes nulles, au moyen d'un réseau composé de P>2 antennes, lorsque les vecteurs directionnels U et V des sources émettant ces signaux sont connus ou estimés par ailleurs.

Il est courant de devoir réaliser l'estimation de signaux radio électriques (débruitage) provenant de radars, de systèmes de communications, ou de signaux acoustiques (audio ou sonar), et reçus par un système d'écoute constitué d'un réseau d'antennes.

Le signal reçu résulte d'un mélange temporel et spectral de 2 sources, dont on suppose que les vecteurs directionnels sont connus, car estimés au préalable.

Le critère classiquement utilisé est le maximum de vraisemblance (MV), conduisant à un traitement par filtrage linéaire spatial qui améliore le rapport signal à bruit par un facteur égal au nombre de capteurs dans le cas monosource.

Dans les hypothèses où l'on se place (vecteurs directionnels connus), ce traitement conduit à une estimation linéaire non biaisée à variance minimale de signaux pour lesquels aucune connaissance a priori n'est disponible.

On connait par exemple du document MASTER A S : « Bayesian two source modeling for separation of n soucres from stereo signals », ACOUSTICS, SPEECH, AND SIGNAL PROCESSING, 2004, un procédé d'estimation de signaux par application d'une technique de Maximisation A Posteriori.

D'autres méthodes dont la mise en œuvre est plus compliquée, peuvent être utilisées, telles que le filtrage de Capon lorsque les vecteurs directionnels sont imparfaitement ou non connus ("Robust Adaptive Beamforming", eds P. Stoica and J. Li, Wiley, 2006).

Aucune de ces méthodes n'exploite d'a priori sur le signal, et en particulier ne permet de délimiter correctement les supports temporel et/ou spectral du signal puisqu'un traitement linéaire (MV) ou pseudo linéaire (Capon) fournit toujours un signal en sortie même si en entrée la mesure n'est composée que de bruit.

Le problème est d'accéder à la connaissance plus fine du signal.

L'invention a pour but de proposer un procédé permettant de déterminer plus finement les composantes du signal.

A cet effet, l'invention a pour objet un procédé d'estimation selon la revendication 1.

Le procédé permet ainsi de répondre aux questions suivantes : pour chacun des signaux en présence (leur nombre étant supposé limité à 2 localement), quels sont les supports temporel et spectral du signal supposé décrit par des composantes obtenues au moyen d'une analyse temps/fréquence ? Et quelle est la valeur de chaque composante lorsqu'elle est non nulle ? La réponse à ces questions permet d'améliorer la connaissance du signal.

Suivant des modes particuliers de réalisation, le procédé comporte une ou plusieurs des caractéristiques des revendications 2 à 9.

L'invention sera mieux comprise à la lecture de la description qui va suivre, faite en se référant aux dessins annexés :

- la figure 1 est une vue schématique illustrant des sources de signal et une installation d'estimation des signaux radioélectriques provenant de ces sources selon l'invention, donnée uniquement à titre indicatif et sans intention de représenter la réalité ;
- la figure 2 est un organigramme d'un des procédés tel que mis en œuvre dans l'invention dans le cas monosource;
- la figure 3 est un organigramme d'un des procédés tel que mis en œuvre dans l'invention dans le cas bisources.

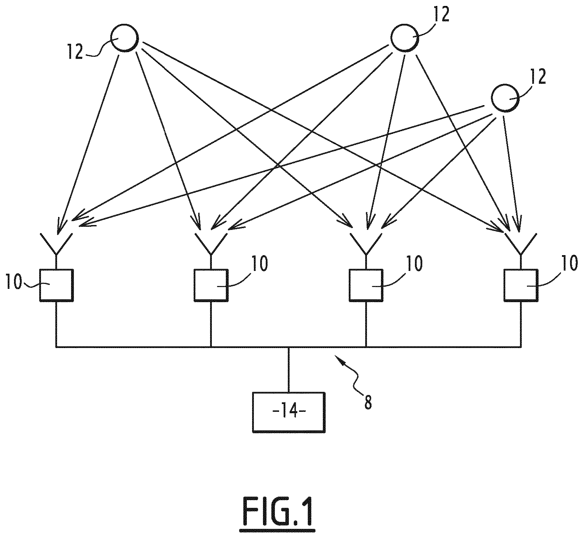

Le dispositif 8 d'estimation d'un mélange de signaux provenant de plusieurs sources 12 selon l'invention illustré à la figure 1 comprend un réseau antennaire composé d'une pluralité d'éléments antennaires 10 ou capteurs. Chaque élément antennaire est couplé à une voie de réception pour, notamment, numériser le signal analogique reçu par chaque capteur.

L'invention est adaptée à la fois aux réseaux antennaires à monopolarisation et aux réseaux antennaires à bipolarisation.

Le dispositif comporte en outre des modules de calcul. Dans différentes variantes de réalisation du dispositif d'estimation de signaux selon l'invention, les modules de calcul peuvent être agencés selon différentes architectures, en particulier chaque étape du procédé peut être implantée par un module distinct ou au contraire l'ensemble des étapes peut être regroupé au sein d'une unité de traitement de l'information unique 14.

La ou les unités de calcul sont reliées aux capteurs par tout moyen adapté pour transmettre les signaux reçus.

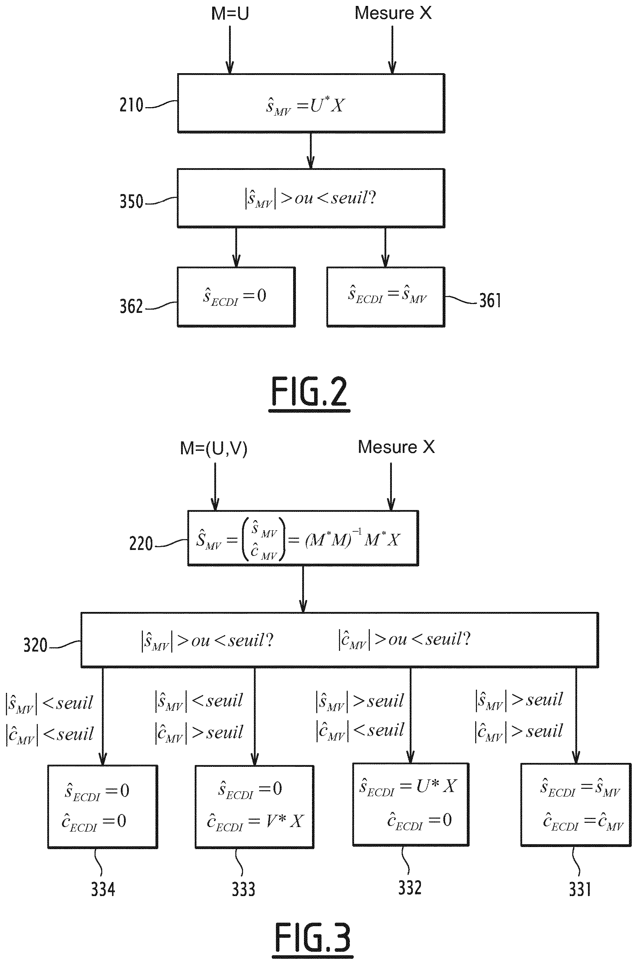

La ou les unités de calcul comportent des moyens de stockage de l'information, ainsi que des moyens de calcul permettant de mettre en œuvre les algorithmes des figures 2 et 3, selon qu'on est dans le cas monosource non-revendiqué ou bisources.

Avantageusement, la réception est faite sur un réseau à diversité d'espace (réseau interférométrique) et la démodulation du signal permettant la « descente en bande de base » est effectuée par le même oscillateur local pour toutes les antennes afin d'assurer une cohérence. Le signal reçu est échantillonné en réel ou en complexe (double démodulation en quadrature ou tout autre procédé) sur chaque voie.

Le signal reçu, filtré dans une bande de typiquement plusieurs centaines de MHz, est modélisé par : $s_0(t)e^{i2\pi f_0 t}$. Ce modèle ne fait pas d'hypothèse sur le type de modulation.

Ce signal est échantillonné à une cadence Te telle que 1/Te >> 2 x bande du signal utile.

On calcule les Transformés de Fourier Discrètes (TFD) pondérées et recouvrantes de ce signal sur $N_{TFD}$ points. La pondération a pour rôle de réduire les lobes secondaires. Comme cette pondération induit une variation de la contribution des données à la TFD (les données au centre du support temporel de la TFD se voyant attribuer un poids beaucoup plus important que les données sur les bords du support), qui peut aller jusqu'à une perte des signaux courts, on prend l'hypothèse d'un recouvrement des supports temporels.

Les mesures recueillies sont donc les résultats des TFD. Elles constituent une grille temps-fréquence, dont les cases sont appelées cases temps-fréquence. Chaque case de la grille contient un vecteur complexe qui est le résultat des Transformées de Fourier Discrètes pour toutes les voies, pour un intervalle temporel et un intervalle fréquentiel donnés.

Pour les fréquences des signaux et les distances qui interviennent ici, on considère que le front d'onde est plan. Donc les antennes reçoivent le signal avec une différence de phase fonction des deux angles entre le plan d'onde et le plan des antennes.

Dans le cas monosource non-revendiqué, les mesures recueillies sur le réseau complet s'écrivent donc comme :

$$X_n = s_n U + W_n$$

- $X_n$ représente les mesures : $X_n$ est un vecteur colonne complexe de dimension P, où P est le nombre de voies et n = 1,2, ... N est un double indice (l,c) parcourant l'espace des temps (indice de la transformée de Fourier) et des fréquences (numéro de canal pour une transformée de Fourier). Plus précisément, l'indice n parcourt les cases d'une fenêtre rectangulaire temporelle x fréquentielle de taille N. Les indices l et c correspondent aux numéros de ligne et de colonne des cases de la fenêtre.
- $s_n$ est un nombre complexe représentant le signal après TFD
- $W_n$ est le bruit thermique dans la case temps/fréquence d'indice n. $W_n$ est un vecteur colonne de dimension P. $W_n$ est gaussien sur ses composantes réelle et imaginaire, indépendant d'une case temps/fréquence à l'autre et indépendant d'une voie antennaire à l'autre. Autrement dit, $W_n$ est blanc spatialement, fréquentiellement et temporellement. L'écart type du bruit compté sur chaque composante réelle ou imaginaire, au niveau d'une case temps/fréquence, est égal à σ. Pour que l'hypothèse d'indépendance du bruit d'une case à l'autre soit vérifiée, on limite le recouvrement des TFD à 50%.

Dans le cas d'un réseau interférométrique monopolarisation, U s'écrit sous la forme :

$$U = g \begin{pmatrix} u_1 \\ ... \\ u_P \end{pmatrix},$$

où g est un scalaire complexe dépendant de la polarisation de l'onde incidente et de sa direction d'arrivée, et où les $u_i$ sont des nombres complexes de module 1 représentant les déphasages géométriques associés à la direction de l'onde incidente. On peut choisir comme référence de phase une des antennes du récepteur.

Dans le cas d'un réseau interférométrique bipolarisation, U s'écrit sous la forme :

$$U = hH + vV ,$$

où h et v sont des scalaires complexes tels que $|h|^2 + |v|^2 = 1$ qui expriment la polarisation de l'onde incidente, et où H (resp V) est la réponse du réseau à une onde polarisée horizontalement (resp verticalement). H et V ne dépendent que de la direction et de la fréquence de l'onde incidente.

Dans tous les cas, U est de dimension P, où P est le nombre d'antennes utilisées.

On peut considérer que U est normé, et que $s_n$ porte la puissance du signal et le gain moyen du réseau.

U est conservé par la TFD qui est une transformation linéaire, et se retrouve sur le signal en sortie de TFD.

Dans le cas général il peut y avoir un mélange de K signaux (K étant éventuellement supérieur à la résolution du réseau). Le signal s'écrit alors :

$$X_n = \sum_{k=1}^{N} s_k(n)U_k + W_n \; ; \text{n=1,2,...N}$$

*Equation 1  Expression d'un mélange de signal*

L'hypothèse fondamentale est que lorsque l'ensemble des N cases temps/fréquence est restreint à une zone rectangulaire ou fenêtre d'indice j, la complexité de l'environnement est telle que dans une telle fenêtre, le mélange des signaux est limité à deux signaux.

Alors le modèle devient :

$$X_{jn} = s_{j1}(n)U_{j1} + s_{j2}(n)U_{j2} + W_n$$

*Equation 2 Expression d'un mélange de signal dans une fenêtre*

Des fenêtres de taille prédéterminée sont définies pour couvrir la grille temps-fréquence. L'ensemble de ces fenêtres forme un découpage de la grille. La taille des fenêtres est choisie de sorte que au plus deux signaux issus de deux sources soient présents dans chaque fenêtre.

Le vecteur U ou les vecteurs U et V désignant le ou les vecteurs directionnels unitaires formé par le signal incident ou les signaux incidents par rapport au réseau sont ensuite extraits (ou estimés), par tout moyen connu adapté.

Une boucle est effectuée pour parcourir l'ensemble des fenêtres définissant le découpage de la grille.

Pour chaque fenêtre, une étape d'estimation du (des) signal (signaux) est mise en œuvre au moyen de l'espérance conditionnelle et des approximations que l'on peut y apporter pour le modèle spécifique des signaux.

Le traitement final se décompose en :

- une étape non linéaire de décision de la situation en chaque case temps/fréquence : source 1 présente et source 2 présente, ou : source 1 présente et source 2 absente, ou : source 1 absente et source 2 présente, ou : source 1 absente et source 2 absente, puis
- une étape de filtrage linéaire spécifique à la situation.

Le traitement obtenu est non biaisé, quasi optimal au sens de l'erreur quadratique moyenne, et délimite en temps/fréquence le support du signal à estimer.

L'estimation du signal s'effectue sur une fenêtre où la situation est monosource ou bisources.

En monosource et de manière non-revendiquée, le signal vectoriel mesuré pour la case d'indice n est

$$X_n = s_n U + W_n, \text{ n=1,2, ...}$$

*Equation 3 Expression du signal mesuré (cas monosource)*

En bisources, on a :

$$X_n = s_n U + c_n V + W_n, \text{ n=1,2, ...}$$

*Equation 4  Expression du signal mesuré (cas bisources)*

Dans les écritures de l'Equation 3 et de l'Equation 4, U et V sont des vecteurs directionnels unitaires d'un réseau monopolarisation ou bipolarisation, $s_n$ et $c_n$ sont des signaux complexes qu'il faut estimer ; $W_n$ est le bruit qui est blanc spatialement et en n, gaussien, centré et de covariance : $E(W_n W_n^*) = 2\sigma^2 I_p$ où $I_p$ est la matrice unité de $C^p$ (P étant le nombre de voies de réception). $^*$ désigne la transposée conjuguée.

Dans la suite, on supposera que U ou V sont estimés par $\hat{U}$ et $\hat{V}$ par exemple à l'aide d'une méthode de type MUSIC, et que cette estimation ayant été faite sur un nombre de cases N >>1, on peut faire l'approximation $U = \hat{U}$, $V = \hat{V}$.

Pour tenir compte du fait que $s_n$ (ou $c_n$) peut être nul pour certains n, sans connaître à l'avance la modulation du signal, on modélise $s_n$ (ou $c_n$) comme des échantillons indépendants en n d'une variable aléatoire dont la densité de probabilité est un mélange (q, 1-q, q<1) de deux gaussiennes centrées de variance respectives $2\sigma_j^2$ (j=1 pour $s_n$ et j=2

pour $c_n$), et $2\tau^2$, avec $\tau^2 < \sigma^2 < \sigma_j^2$. $2\sigma_j^2$ est la puissance du signal utile s'il est présent lorsqu'on néglige $\tau^2$ dans

l'expression $(1-q)2\tau^2 + q2\sigma_j^2$ de la puissance moyenne.

$\tau$ est un paramètre de régularisation du modèle qui permet d'appliquer la formule de Bayes pour des lois de probabilité admettant des densités de probabilité par rapport à la mesure de Lebesgue ; cependant la réalité physique est qu'il y a absence de signal lorsqu'on modélise celui-ci au moyen de la gaussienne centrée de variance $2\tau^2$ (puissance $2\tau^2$). C'est pourquoi, à la fin des calculs, on ne garde que la limite des expressions lorsque $\tau \to 0$.

$s_n$ et $c_n$ sont considérés comme indépendants.

Le signal mesuré s'écrit dans les deux cas, monosource ou bisources, sous la forme unique :

$$X_n = MS_n + W_n \text{ ,n=1,2,...N}$$

*Equation 5  Forme matricielle du signal mesuré*

où $M = U$ et $S_n = s_n$ en monosource, et $M = (U\ V)$, $S_n = (s_n\ c_n)^T$ en bisources, avec M connue et $\sigma^2$ connu.

Dans la suite du document, pour alléger les notations, étant entendu que le traitement opère sur chaque case d'indice $n$ indépendamment, on omet l'indice $n$ et on note X la mesure dans une case temps/fréquence, s le signal monosource non-T revendiqué et $S = (s\ c)^T$ le signal bisources dans une case temps/fréquence.

Les connaissances a priori sur S sont données par une densité de probabilité. Dans le cas monosource non-revendiqué :

$$p(s) = \frac{q}{2\pi\sigma_1^2}\exp\left(-\frac{|s|^2}{2\sigma_1^2}\right) + \frac{1-q}{2\pi\tau^2}\exp\left(-\frac{|s|^2}{2\tau^2}\right)$$

*Equation 6  Densité de probabilité du signal (cas monosource)*

Dans le cas bisources :

$$p(S) = \sum_j \frac{q_j}{\pi^2 \det C_j}\exp\left(-S^* C_j^{-1} S\right)$$

*Equation 7 Densité de probabilité du signal (cas bisources)*

où $q_1 = q^2$, $q_2 = q_3 = q(1 - q)$, $q_4 = (1 - q)^2$ si les sources sont considérées comme indépendantes et équiprobables (dans la suite on généralise à une répartition $q_1, q_2, q_3, q_4$ des 4 situations non liées par les expressions ci-dessus),
Et

$$C_1 = \begin{pmatrix} 2\sigma_1^2 & 0 \\ 0 & 2\sigma_2^2 \end{pmatrix}, C_2 = \begin{pmatrix} 2\sigma_1^2 & 0 \\ 0 & 2\tau^2 \end{pmatrix}, C_3 = \begin{pmatrix} 2\tau^2 & 0 \\ 0 & 2\sigma_2^2 \end{pmatrix}, C_4 = \begin{pmatrix} 2\tau^2 & 0 \\ 0 & 2\tau^2 \end{pmatrix}$$

*Equation 8 Matrices de covariance du signal*

sont les matrices de covariances de S pour les quatre cas possibles.

On estime S au moyen de l'espérance conditionnelle en utilisant les modèles monosource non-revendiqué et bisources (Equation 5, Equation 6 et Equation 5, Equation 7).

L'Espérance Conditionnelle (EC) est l'estimateur $\hat{S}$ qui minimise l'écart quadratique moyen $E(\|S - \hat{S}\|^2)$. Il est de plus non biaisé, et donne une solution explicite pour $\hat{S}$. Il est construit de la façon suivante :

Soit X la mesure ; sa densité de probabilité qui dépend du paramètre à estimer S est interprétée comme la densité de probabilité conditionnelle de X sachant S. On dispose donc de $p(X/S)$ et de $p(S)$ provenant de la connaissance a priori de S.

S est donnée par la formule explicite :

$$\hat{S} = \int\limits_{domS} S p(S/X) dS$$

*Equation 9 Estimation de S*

$p(S/X)$, la densité de probabilité conditionnelle de S sachant X, est obtenue par la formule de Bayes.

$$p(S/X) = \frac{p(X/S).p(S)}{p(X)}$$

*Equation 10 Ecriture générale de la densité de probabilité conditionnelle de S sachant X*

$$\text{Avec } p(X) = \int\limits_{domS} p(X/S).p(S) dS$$

*Equation 11 Ecriture générale de la densité de probabilité de X*

Dans le cas où $X = MS + V$ et $p(S)$ est gaussienne, centrée de covariance C, on peut trouver analytiquement $\hat{S}$, ce qui n'est pas le cas en général.

C'est une fonction linéaire de X. En effet (en dimension 2) :

$$p(X/S) = \frac{1}{\pi^2 4\sigma^4} \exp\left( -\frac{\|X - MS\|^2}{2\sigma^2} \right)$$

$$p(S) = \frac{1}{\pi^2 \det C} \exp\left( -S^* C^{-1} S \right)$$

$$p(X/S)p(S) = \frac{1}{\pi^4 4\sigma^4 \det C} \exp\left( -\frac{\|X\|^2}{2\sigma^2} + \frac{X^* MS}{2\sigma^2} + \frac{S^* M^* X}{2\sigma^2} - \frac{S^* M^* MS}{2\sigma^2} - S^* C^{-1} S \right)$$

Posons

$$\Sigma^{-1} = \frac{M^* M}{2\sigma^2} + C^{-1}$$

En complétant le « carré » en S, on a :

$$p(X/S)p(S) = \frac{K_2}{\det C} \exp\left( -\left( S - \frac{\Sigma}{2\sigma^2} M^* X \right)^* \Sigma^{-1} \left( S - \frac{\Sigma}{2\sigma^2} M^* X \right) - \frac{\|X\|^2}{2\sigma^2} + \frac{X^* M\Sigma M^* X}{4\sigma^4} \right)$$

où $K_2$ est une constante ($=1/\pi^4 4\sigma^4$) en dimension 2. $\Sigma$ est une matrice hermitienne définie positive. On en déduit :

$$\int\limits_{domS} p(X/S)p(S) dS = \frac{K_2 \pi^2 \det \Sigma}{\det C} \exp\left( -\frac{\|X\|^2}{2\sigma^2} + \frac{X^* M\Sigma M^* X}{4\sigma^4} \right)$$

*Equation 12 Densité de probabilité des mesures en bisources*

$$\int_{domS} S.p(X/S)p(S)dS = \frac{K_2\pi^2 \det\Sigma}{\det C}\exp\left(-\frac{\|X\|^2}{2\sigma^2}+\frac{X^*M\Sigma M^*X}{4\sigma^4}\right).\frac{\Sigma}{2\sigma^2}M^*X$$

*Equation 13 Densité de probabilité conditionnelle de S sachant X en bisources*

Les expressions complètes de l'Equation 12 serviront à trouver l'estimateur recherché pour notre problème.

Dans le cas où S est un échantillon gaussien, les Equation 9, Equation 10, Equation 11, Equation 12, et Equation 13 donnent :

$$\hat{S} = \frac{\Sigma}{2\sigma^2}M^*X$$

*Equation 14 Estimation de S en bisources (cas où S est gaussien)*

qu'on peut écrire aussi :

$$\hat{S} = \left(2\sigma^2\Sigma^{-1}\right)^{-1}M^*X = \left(M^*M + 2\sigma^2C^{-1}\right)^{-1}M^*X$$

On en conclut que si $2\sigma^2 C^{-1} \ll M^*M$, $\hat{S}$ se réduit à l'estimateur du maximum de vraisemblance de S au moyen du modèle de l'Equation 5 sans connaissance a priori sur $S$ : $\hat{S}_{MV} = (M^*M)^{-1}M^*X$.

La condition $2\sigma^2 C^{-1} \ll M^*M$ en tant que matrices, s'exprime aussi par $C \gg 2\sigma^2(M^*M)^{-1}$ qui signifie que l'a priori sur S qui est défini par C n'apporte pas d'information réelle sur S.

L'estimée du signal dans le cas monosource non-revendiqué est telle qu'indiquée ci-dessous.

Dans le cas monodimensionnel non-revendiqué pour S=s (monosource), on a M=U et donc $M^*M = 1$ ;

La matrice C est réduite à la constante c ;

$$p(X/S)p(S) = \frac{1}{2\pi\sigma^2}\exp\left(-\frac{\|X-Us\|^2}{2\sigma^2}\right) \; ; \; p(s) = \frac{1}{\pi.c}\exp\left(-\frac{|s|^2}{c}\right)$$

On en déduit

$$\Sigma^{-1} = \frac{1}{2\sigma^2}+\frac{1}{c} \text{ ou } \Sigma = \frac{2\sigma^2 c}{2\sigma^2 + c}$$

$$p(X/S)p(S) = \frac{K_1}{c}\exp\left(-\frac{2\sigma^2+c}{2\sigma^2 c}\left|1-\frac{c}{2\sigma^2+c}U^*X\right|^2 - \frac{\|X\|^2}{2\sigma^2}+\frac{c}{2\sigma^2\left(2\sigma^2+c\right)}\left|U^*X\right|^2\right)$$

avec

$$K_1 = \frac{1}{2\pi\sigma^2}$$

Il vient alors :

$$\int_{doms} s.p(X/S).p(S) = \frac{K_1}{c}\pi\frac{2\sigma^2 c}{2\sigma^2 + c}\exp\left(-\frac{\|X\|^2}{2\sigma^2}+\frac{c}{2\sigma^2\left(2\sigma^2 + c\right)}\left|U^*X\right|^2\right)\cdot\frac{c}{2\sigma^2 + c}U^*X$$

*Equation 15 Densité de probabilité conditionnelle de S sachant X en monosource*

$$\int_{doms} p(X/S)p(S) = \frac{K_1}{c}\pi\frac{2\sigma^2 c}{2\sigma^2 + c}\exp\left(-\frac{\|X\|^2}{2\sigma^2}+\frac{c}{2\sigma^2\left(2\sigma^2 + c\right)}\left|U^*X\right|^2\right)$$

*Equation 16 Densité de probabilité des mesures en monosource*

On obtient l'espérance conditionnelle, dans le cas gaussien pour s, par le quotient de l'Equation 15 par l'Equation 16 :

$$\hat{s} = \frac{c}{2\sigma^2 + c}U^*X$$

*Equation 17 Estimation de s en monosource (cas où s est gaussien)*

**Si** $c >> 2\sigma^2$, ce qui exprime qu'on n'a pas d'information a priori sur s, $\hat{s}$ se réduit à l'estimateur du maximum de vraisemblance : $\hat{S}_{MV} = U^*X$

L'estimée du signal dans le cas bisources est telle qu'indiquée ci-dessous.

L'estimateur de l'espérance conditionnelle est obtenu grâce à l'Equation 15 et à l'Equation 16 pour la densité mélange de S donnée par l'Equation 7.

$$K_2\pi^2\exp\left(-\frac{\|X\|^2}{2\sigma^2}\right)$$

Après simplification par le facteur commun $\qquad\qquad\qquad\qquad$ dans tous les termes au numérateur et au dénominateur, on obtient :

$$\hat{S} = \frac{\sum_j q_j\dfrac{\det\Sigma_j}{\det C_j}\exp\left(\dfrac{1}{4\sigma^4}X^*M\Sigma_j M^*X\right)\dfrac{\Sigma_j}{2\sigma^2}M^*X}{\sum_j q_j\dfrac{\det\Sigma_j}{\det C_j}\exp\left(\dfrac{1}{4\sigma^4}X^*M\Sigma_j M^*X\right)}$$

*Equation 18 Espérance conditionnelle en bisources*

Avec

$$\Sigma_j^{-1} = \frac{M^*M}{2\sigma^2} + C_j^{-1}\text{ ou }\Sigma_j = 2\sigma^2\left(M^*M + 2\sigma^2 C_j^{-1}\right)^{-1}$$

Posons $\quad\Gamma_j = 2\sigma^2 C_j^{-1}\quad$ (sans dimension),

$$Q_j = \left(M^*M + 2\sigma^2 C_j^{-1}\right)^{-1} = \left(M^*M + \Gamma_j\right)^{-1} = \Sigma_j / 2\sigma^2$$

On a :

$$\hat{S} = \frac{\sum_{j=1}^{4} q_j \det Q_j \det \Gamma_j \exp\left(\dfrac{X^* M Q_j M^* X}{2\sigma^2}\right) Q_j M^* X}{\sum_{j=1}^{4} q_j \det Q_j \det \Gamma_j \exp\left(\dfrac{X^* M Q_j M^* X}{2\sigma^2}\right)}$$

*Equation 19 Espérance conditionnelle en bisources*

D'après l'Equation 8,

$$M^* M = \begin{pmatrix} 1 & U^* V \\ V^* U & 1 \end{pmatrix}$$

$$\Gamma_1 = \begin{pmatrix} \sigma^2/\sigma_1^2 & 0 \\ 0 & \sigma^2/\sigma_2^2 \end{pmatrix}, \quad Q_1^{-1} = \begin{pmatrix} 1+\sigma^2/\sigma_1^2 & U^* V \\ V^* U & 1+\sigma^2/\sigma_2^2 \end{pmatrix}$$

$$\Gamma_2 = \begin{pmatrix} \sigma^2/\sigma_1^2 & 0 \\ 0 & \sigma^2/\tau^2 \end{pmatrix}, \quad Q_2^{-1} = \begin{pmatrix} 1+\sigma^2/\sigma_1^2 & U^* V \\ V^* U & 1+\sigma^2/\tau^2 \end{pmatrix}$$

$$\Gamma_3 = \begin{pmatrix} \sigma^2/\tau^2 & 0 \\ 0 & \sigma^2/\sigma_2^2 \end{pmatrix}, \quad Q_3^{-1} = \begin{pmatrix} 1+\sigma^2/\tau^2 & U^* V \\ V^* U & 1+\sigma^2/\sigma_2^2 \end{pmatrix}$$

$$\Gamma_4 = \begin{pmatrix} \sigma^2/\tau^2 & 0 \\ 0 & \sigma^2/\tau^2 \end{pmatrix}, \quad Q_4^{-1} = \begin{pmatrix} 1+\sigma^2/\tau^2 & U^* V \\ V^* U & 1+\sigma^2/\tau^2 \end{pmatrix}$$

On en déduit :

$$Q_1 = \frac{1}{\left(1+\sigma^2/\sigma_1^2\right)\left(1+\sigma^2/\sigma_2^2\right) - \left|U^* V\right|^2} \begin{pmatrix} 1+\sigma^2/\sigma_2^2 & -U^* V \\ -V^* U & 1+\sigma^2/\sigma_1^2 \end{pmatrix}$$

$$Q_2 = \frac{1}{\left(1+\sigma^2/\sigma_1^2\right)\left(1+\sigma^2/\tau^2\right) - \left|U^* V\right|^2} \begin{pmatrix} 1+\sigma^2/\tau^2 & -U^* V \\ -V^* U & 1+\sigma^2/\sigma_1^2 \end{pmatrix}$$

$$Q_3 = \frac{1}{\left(1+\sigma^2/\tau^2\right)\left(1+\sigma^2/\sigma_2^2\right) - \left|U^* V\right|^2} \begin{pmatrix} 1+\sigma^2/\sigma_2^2 & -U^* V \\ -V^* U & 1+\sigma^2/\tau^2 \end{pmatrix}$$

$$Q_4 = \frac{1}{\left(1+\sigma^2/\tau^2\right)^2 - \left|U^* V\right|^2} \begin{pmatrix} 1+\sigma^2/\tau^2 & -U^* V \\ -V^* U & 1+\sigma^2/\tau^2 \end{pmatrix}$$

*Equation 20 Matrices Qi*

L'expression de l'estimée du signal fait l'objet d'une approximation pour permettre son estimation comme indiqué ci-dessous dans le cas bisources.

Les produits de déterminants dans l'Equation 19 sont respectivement égaux aux expressions suivantes dont on donne une approximation pour un bon rapport signal à bruit ( $\sigma_1^2/\sigma^2 \gg 1$ et $\sigma_2^2/\sigma^2 \gg 1$ ) et pour $\tau \to 0$.

$$\det Q_1 \det \Gamma_1 = \left[\left(1+\sigma^2/\sigma_1^2\right)\left(1+\sigma^2/\sigma_2^2\right)-\left|U^*V\right|^2\right]^{-1}\sigma^4/\sigma_1^2\sigma_2^2 \approx \left(1-\left|U^*V\right|^2\right)^{-1}\sigma^4/\sigma_1^2\sigma_2^2$$

$$\det Q_2 \det \Gamma_2 = \left[\left(1+\sigma^2/\sigma_1^2\right)\left(1+\sigma^2/\tau^2\right)-\left|U^*V\right|^2\right]^{-1}\sigma^4/\sigma_1^2\tau^2 \approx \left(\tau^2/\sigma^2\right)\left(1+\sigma^2/\sigma_1^2\right)^{-1}\cdot\left(\sigma^4/\sigma_1^2\tau^2\right) \approx \sigma^2/\sigma_1^2$$

$$\det Q_3 \det \Gamma_3 = \left[\left(1+\sigma^2/\tau^2\right)\left(1+\sigma^2/\sigma_2^2\right)-\left|U^*V\right|^2\right]^{-1}\sigma^4/\sigma_2^2\tau^2 \approx \sigma^2/\sigma_2^2$$

$$\det Q_4 \det \Gamma_4 = \left[\left(1+\sigma^2/\tau^2\right)^2-\left|U^*V\right|^2\right]^{-1}\sigma^4/\tau^4 \approx 1$$

*Equation 21 Det Qi det Π*

De même, on trouve pour $Q_j$ lorsque $\tau \to 0$ :
$Q_1$ est inchangé.

$$Q_1 \approx \frac{1}{\left(1+\sigma^2/\sigma_1^2\right)\left(1+\sigma^2/\sigma_2^2\right)-\left|U^*V\right|^2}\begin{pmatrix} 1 & -U^*V \\ -V^*U & 1 \end{pmatrix}$$

$$Q_2 \approx \begin{pmatrix} 1/\left(1+\sigma^2/\sigma_1^2\right) & 0 \\ 0 & 0 \end{pmatrix}$$

$$Q_3 \approx \begin{pmatrix} 0 & 0 \\ 0 & 1/\left(1+\sigma^2/\sigma_2^2\right) \end{pmatrix}$$

$$Q_4 \approx \begin{pmatrix} 0 & 0 \\ 0 & 0 \end{pmatrix}$$

*Equation 22 Forme simplifiée des matrices Qi*

On observe que les produits det $Q_j$ det $\Gamma_j$ ont une limite finie dans chacune des quatre situations, de même que les matrices $Q_j$, ce qui est un comportement satisfaisant.

On a ainsi obtenu une première expression de l'estimateur.

En réalité seul un des termes dans l'Equation 19 est prépondérant pour chaque case, ce qui conduit à une première simplification. On en déduit le nouveau traitement d'estimation des Ŝ.

$$\hat{S} = Q_{j0}M^*X \text{ où } j_0 = Arg\,Max_j\left\{q_j\det Q_j\det\Gamma_j\exp\left(X^*MQ_jM^*X/2\sigma^2\right)\right\}$$

Ce que l'on simplifie en :

$$\hat{S} = Q_{j0}M^*X \text{ où } j_0 = Arg\,Max_j F_j = Arg\,Max_j\left\{\ln\left(q_j\det Q_j\det\Gamma_j\right)+X^*MQ_jM^*X/2\sigma^2\right\}$$

*Equation 23 Estimation du signal avec fonction de décision*

$$M^{*}X = \begin{pmatrix} U^{*}X \\ V^{*}X \end{pmatrix}$$

$M^{*}X$ est donné par :

Les det $Q_{j}$.det $\Gamma_{j}$ sont donnés par l'Equation 21.

Les $Q_{j}$ sont donnés par l'Equation 22,

$$\text{Les } q_{j} \text{ sont donnés par exemple par } q_{j} = \begin{cases} q^{2}, j=1 \\ q(1-q), j=2,3 \\ (1-q)^{2}, j=4 \end{cases}$$

*Equation 24 Expression des paramètres $q_{j}$*

s'il y a indépendance des 4 situations et équiprobabilité pour $s \neq 0, c \neq 0$.

*F(j)* est donné par :

$$F(j_{1}) = \ln(q_{1} \det Q_{1} \det \Gamma_{1}) + X^{*}MQ_{1}M^{*}X / 2\sigma^{2} = \ln\left(q^{2}\left(1 - |U^{*}V|^{2}\right)\sigma^{4} / \sigma_{1}^{2}\sigma_{2}^{2}\right) + X^{*}MQ_{1}M^{*}X / 2\sigma^{2}$$

$$F(j_{2}) = \ln(q_{2} \det Q_{2} \det \Gamma_{2}) + X^{*}MQ_{2}M^{*}X / 2\sigma^{2} = \ln\left(q(1-q)\sigma^{2} / \sigma_{1}^{2}\right) + X^{*}UU^{*}X / 2\sigma^{2}$$

$$F(j_{3}) = \ln(q_{3} \det Q_{3} \det \Gamma_{3}) + X^{*}MQ_{3}M^{*}X / 2\sigma^{2} = \ln\left(q(1-q)\sigma^{2} / \sigma_{2}^{2}\right) + X^{*}VV^{*}X / 2\sigma^{2}$$

$$F(j_{4}) = \ln(q_{4} \det Q_{4} \det \Gamma_{4}) + X^{*}MQ_{4}M^{*}X / 2\sigma^{2} = \ln\left((1-q)^{2}\right)$$

Pour $j_{0}$ = 1, on retrouve l'estimateur du maximum de vraisemblance. En effet dans ce cas

$$\Gamma_{1} = \begin{pmatrix} \sigma^{2} / \sigma_{1}^{2} & 0 \\ 0 & \sigma^{2} / \sigma_{2}^{2} \end{pmatrix} \approx 0$$

et $Q_{1} = (M^{*}M)^{-1}$ de sorte que $\hat{S} = (M^{*}M)^{-1}M^{*}X$. On constate que si $U^{*}V = 0$, alors les estimations de *s* et de c sont complètement séparées, car alors, la relation $\hat{S} = (M^{*}M)^{-1}M^{*}X$ se simplifie et se découple en $\hat{s} = U^{*}X$, $\hat{c} = V^{*}X$.

Pour $j_{0}$ = 2, $\hat{S}^{T} = (U^{*}X, 0)$ (filtrage par le vecteur directionnel de la source 1)
Pour $j_{0}$ = 3, $\hat{S}^{T} = (0, V^{*}X)$ (filtrage par le vecteur directionnel de la source 2)
Pour $j_{0}$ = 4 , $\hat{S}^{T} = (0,0)$

Où le symbole $^{T}$ désigne la transposée.

On a ainsi « linéarisé » le traitement optimal, puisqu'on a obtenu quatre filtres linéaires, commandés par la décision sur le type de situation pour chaque case : les deux sources sont présentes / la source 1 est présente / la source 2 est présente / aucune des deux sources n'est présente. On appelle l'estimateur obtenu « Espérance Conditionnelle à 4 Filtres Linéaires ».

De cette façon, on a simplifié l'estimateur optimal, en le décomposant en deux étapes :

- La détection de la situation
- L'application d'un filtrage approprié à la situation

Il est satisfaisant de constater que l'estimateur est indépendant de $\tau$, ce qui est le comportement attendu puisque $\tau$ n'est pas un paramètre physique, mais un artifice permettant de modéliser la situation « absence de signal » par une gaussienne très pincée.

Cet estimateur nécessite le calcul de trois formes quadratiques et d'un test. Le point dur reste le calcul des paramètres inconnus $q_{j,j=1...4}$, $\sigma_1^2, \sigma_2^2$ (la puissance du bruit $2\sigma^2$ est supposée connue).

Dans le cas particulier où les 2 sources sont indépendantes, et ont la même puissance et le même taux de présence, les paramètres peuvent être estimés en calculant les moments empiriques d'ordre 2 et 4.

Si on appelle $2\sigma'^2$ la valeur commune de la variance de la gaussienne représentant chaque source, et q la probabilité commune aux 2 sources, tout se passe comme si on était dans une situation monosource, avec une source unique de variance $2\sigma_M'^2 = 2\sigma'^2$ et de probabilité de présence $q_M = 2q$. $\sigma_M'^2$ et $q_M$ sont alors donnés par les équations suivantes :

$$\begin{cases} \dfrac{1}{N}\sum_n |X_n|^2 & = \ 2q_M\left(\dfrac{\sigma_M'^2}{P}+\sigma^2\right)+(1-q_M)2\sigma^2 \\[4ex] \dfrac{1}{N}\sum_n |X_n|^4 & = \ 8q_M\left(\dfrac{\sigma_M'^2}{P}+\sigma^2\right)^2+8(1-q_M)\sigma^4 \end{cases}$$

Dans le cas général (sources indépendantes), les paramètres du modèle sont au nombre de 4 : $q_1, q_2, \sigma_1^2, \sigma_2^2$. L'homme de l'art sait généraliser la méthode des moments ci-dessus aux ordres supérieurs pour obtenir les estimations de ces paramètres.

Une variante du traitement d'estimation consiste à simplifier l'étape de décision décrit précédemment, comme suit :

L'espérance conditionnelle considère les quatre situations possibles :

$$s \neq 0, c \neq 0; s \neq 0, c = 0; s = 0, c \neq 0; s = 0, c = 0$$

Il faudrait normalement traiter un problème de décision à quatre hypothèses.

Pour simplifier, on propose de tester $s \neq 0$ contre s = 0 indépendamment de c d'une part, et de tester $c \neq 0$ contre c = 0 indépendamment de s d'autre part. On effectue donc deux tests à deux hypothèses au lieu d'un test à quatre hypothèses.

Ces tests seront effectués à partir des mesures prétraitées $U^*X, V^*X$.

**TEST DE** $s \neq 0$ **CONTRE** s = 0

$$H_1 : \begin{cases} U^*X = s + U^*V.c + u \\ V^*X = V^*U.s + c + v \end{cases}, \ s \neq 0$$

$$H_0 : \begin{cases} U^*X = U^*V.c + u \\ V^*X = c + v \end{cases}, \ s \neq 0$$

*Equation 25 Test d'hypothèse simplifié : les 2 hypothèses pour s*

où les (.) indiquent le produit scalaire x scalaire
et où $u = U^*W$, $v = V^*W$ : $(u, v)$ est donc gaussien, centré et de covariance :

$$E\left\{\begin{pmatrix} U^*W \\ V^*W \end{pmatrix}\begin{pmatrix} W^*U & W^*V \end{pmatrix}\right\} = 2\sigma^2\begin{pmatrix} 1 & U^*V \\ V^*U & 1 \end{pmatrix},$$

et où c est un paramètre inconnu.

C'est un problème invariant par le groupe des translations de vecteur $(U^*V\ 1)^T$ et un problème à hypothèse linéaire (voir "Testing Statistical Hypothesis", 3rd edition, E.L. Lehmann, J.P. Romano, Springer, 2005). Il peut être traité en effectuant premièrement une projection sur l'orthogonal de $(U*V1)^T$ pour éliminer c, puis en testant la présence de s par un test du chi2.

La projection s'écrit :

$$U^*X - \left(U^*V\right)V^*X = \begin{cases} \left(1 - \left|U^*V\right|^2\right)s + u - \left(U^*V\right)v & (H_1) \\ u - \left(U^*V\right)v & (H_0) \end{cases}$$

Le test à **effectuer** porte donc sur la mesure $|U^*X - (U^*V)V^*X|^2$ :

$$\left|U^*X - \left(U^*V\right)V^*X\right|^2 > ou < \lambda$$

*Equation 26 Test d'hypothèse simplifié sur s*

$$\left|\hat{s}_{MV}\right|^2 = \frac{\left|U^*X - \left(U^*V\right)V^*X\right|^2}{\left(1 - \left|U^*V\right|^2\right)} > ou < \lambda'$$

Ce qui revient au même que de faire le test : , où $\hat{s}_{MV}$ est l'estimée au sens du maximum de vraisemblance de s.

**TEST DE** $c \neq 0$ **CONTRE** $c = 0$

De la même manière pour c, on projette M*X sur l'orthogonal de $(1\ V^*U)^T$ afin d'éliminer les termes en s et on obtient la nouvelle mesure à considérer :

$$-\left(V^*U\right)U^*X + V^*X = \begin{cases} \left(1 - \left|U^*V\right|^2\right)c + v - \left(V^*U\right)u & (H'_1) \\ v - \left(V^*U\right)u & (H'_0) \end{cases}$$

On obtient le test suivant :

$$\left|\left(V^*U\right)U^*X - V^*X\right|^2 > ou < \mu$$

*Equation 27 Test d'hypothèse simplifié sur c*

$$\left|\hat{c}_{MV}\right|^2 = \frac{\left|\left(V^*U\right)U^*X - V^*X\right|^2}{\left(1 - \left|U^*V\right|^2\right)} > ou < \mu'$$

que l'on peut écrire

où $\hat{c}_{MV}$ est l'estimée de c au sens du maximum de vraisemblance de c.

En bisources l'estimateur proposé consiste à effectuer les opérations suivantes :
Comme illustré sur la figure 3, à partir du calcul de l'estimateur du maximum de vraisemblance bisources $\hat{S}_{MV} = (\hat{s}, \hat{c}) = (M^*M)^{-1}M^*X$ effectué à l'étape 220, un seuillage du module de chaque composante de $\hat{S}_{MV}$ est effectué à l'étape 320 sur chacune des composantes $|\hat{s}_{MV}|$ et $|\hat{c}_{MV}|$.

Puis en fonction de la situation, un filtrage spatial est appliqué aux étapes 331 à 334 dans les conditions suivantes, ce qui permet d'obtenir l'estimateur dit de l'Espérance Conditionnelle à Décisions Indépendantes (ECDI) :

○

$$\text{Si } \left|\hat{s}_{MV}\right| > seuil \text{ et } \left|\hat{c}_{MV}\right| > seuil \; : \; \hat{S}_{ECDI} = \left(M^*M\right)^{-1} M^*X \quad \text{(étape 331)}$$

$$\text{Si } \left|\hat{s}_{MV}\right| > seuil \text{ et } \left|\hat{c}_{MV}\right| < seuil \; : \; \hat{s}_{ECDI} = U^*X \;, \; \hat{c}_{ECDI} = 0 \quad \text{(étape 332)}$$

$$\text{Si } \left|\hat{s}_{MV}\right| < seuil \text{ et } \left|\hat{c}_{MV}\right| > seuil \; : \; \hat{s}_{ECDI} = 0 \;, \; \hat{c}_{ECDI} = V^*X \quad \text{(étape 333)}$$

$$\text{Si } \left|\hat{s}_{MV}\right| < seuil \text{ et } \left|\hat{c}_{MV}\right| < seuil \; : \; \hat{S}_{ECDI} = 0 \quad \text{(étape 334)}$$

Dans le cas monosource non-revendiqué, l'estimateur proposé consiste à effectuer les opérations suivantes, comme illustré sur la figure 2 :

A partir du calcul de l'estimateur du maximum de vraisemblance $\hat{S}_{MV} = U^*X$ effectué à l'étape 210, un seuillage du module de $\hat{S}_{MV}$ est effectué à l'étape 350, puis, en fonction de la situation, un filtrage spatial est appliqué aux étapes 361 ou 362 dans les conditions suivantes :

$$\text{Si } \left|\hat{s}_{MV}\right| > seuil \; \hat{s}_{ECDI} = U^*X \quad \text{(étape 361)}$$

$$\text{Si } \left|\hat{s}_{MV}\right| < seuil \; \hat{s}_{ECDI} = 0 \quad \text{(étape 362)}$$

Avantageusement, le seuil pour les étapes 320, 350 est fixé de la manière suivante :

On appelle Pfa, la probabilité de décider s ≠ 0 alors que s = 0 et Pd, probabilité de décider s ≠ 0 alors que s ≠ 0 .

On propose par exemple et de manière nullement limitative, d'utiliser le critère de Neyman-Pearson qui consiste à fixer la Pfa (par exemple quelques pourcent) et en contrepartie à maximiser Pd, ce qui permet d'obtenir un seuil sur $\lambda'$ et $\mu'$. Par exemple, et de manière nullement limitative, on peut également régler la valeur de $\lambda'$ (resp $\mu'$) de telle sorte que 1 - Pd = Pfa autour d'un RSB fixé.

Une variante proche du Maximum de Vraisemblance et appelée Maximum de Vraisemblance Seuillé (MVS) consiste à effectuer les opérations suivantes :

- Calcul de l'estimateur du maximum de vraisemblance $\hat{S}_{MV} = (M^*M)^{-1}M^*X$

- Seuillage du module des composantes de $\hat{S}_{MV}$

- En fonction de la situation, application d'un filtrage spatial

$$\text{Si } \left|\hat{s}_{MV}\right| < seuil \; : \; \hat{s}_{MVS} = 0 \;, \text{ sinon } \hat{s}_{MVS} = \hat{s}_{MV}$$

$$\text{Si } \left|\hat{c}_{MV}\right| < seuil \; : \; \hat{c}_{MVS} = 0 \;, \text{ sinon } \hat{c}_{MVS} = \hat{c}_{MV}$$

Une autre variante consiste à utiliser l'un des deux estimateurs précédents pour obtenir une initialisation des paramètres inconnus $q_{j,j=1..4}$ , $\sigma_1^2$ , $\sigma_2^2$ , puis à appliquer l'estimateur de l'Espérance Conditionnelle ou l'estimateur de l'Espérance Conditionnelle à 4 Filtres Linéaires.

**Revendications**

1. Procédé d'estimation par des moyens de calcul, de deux signaux mélangés issus de sources distinctes, dont la représentation en temps/fréquence fait apparaître une proportion non nulle inconnue de composantes nulles, au moyen d'un réseau composé de P>2 antennes, lorsque les vecteurs directionnels $U$ et $V$ des sources émettant ces signaux sont connus ou estimés par ailleurs, comportant les étapes suivantes :

   a) Calculer les Transformées de Fourier Discrètes successives du signal reçu par les antennes et échantillonné pour obtenir une grille P-vectorielle temps-fréquence du signal ; chaque élément de la grille étant appelé case et contenant un vecteur complexe X formant une mesure ;
   b) Pour chaque case, calculer une estimée du signal bi-sources $S = (s, c)^T$, $s$ étant le signal associé à la première source, et c le signal associé à la deuxième source, et $(.)^T$ étant la transposée de $(.)$, $\hat{S} = (\hat{s}, \hat{c})^T$, au moyen d'une approximation de l'estimateur de l'espérance conditionnelle du signal, ou des signaux, la densité de probabilité de S étant modélisée comme un mélange de gaussiennes centrées pondérées par des coefficients $q_1, q_2, q_3, q_4$ des quatre situations possibles en chaque case parmi respectivement, présence des deux sources, présence de la source 1 et absence de la source 2, absence de la source 1 et présence de la source 2, absence des deux sources, cette approximation s'écrivant sous la forme :

$$\hat{S} = \frac{\sum_{j=1}^{4} q_j \det Q_j \det \Gamma_j \exp\left(\dfrac{X^* M Q_j M^* X}{2\sigma^2}\right) Q_j M^* X}{\sum_{j=1}^{4} q_j \det Q_j \det \Gamma_j \exp\left(\dfrac{X^* M Q_j M^* X}{2\sigma^2}\right)}$$

où $(.)^*$ désigne le transposé conjugué de la matrice $(.)$ ;
et où :

$$Q_1 = \frac{1}{(1 + \sigma^2/\sigma_1^2)(1 + \sigma^2/\sigma_2^2) - |U^* V|^2} \begin{pmatrix} 1 & -U^* V \\ -V^* U & 1 \end{pmatrix}$$

$$Q_2 = \begin{pmatrix} 1/(1 + \sigma^2/\sigma_1^2) & 0 \\ 0 & 0 \end{pmatrix}$$

$$Q_3 = \begin{pmatrix} 0 & 0 \\ 0 & 1/(1 + \sigma^2/\sigma_2^2) \end{pmatrix}$$

$$Q_4 = \begin{pmatrix} 0 & 0 \\ 0 & 0 \end{pmatrix} ;$$

et où $\det Q_1 \det \Gamma_1$, $\det Q_2 \det \Gamma_2$ , $\det Q_3 \det \Gamma_3$, $\det Q_4 \det \Gamma_4$ sont pris respectivement égaux à :

$$\left(1 - |U^* V|^2\right)^{-1} \sigma^4/\sigma_1^2 \sigma_2^2, \; \sigma^2/\sigma_1^2, \; \sigma^2/\sigma_2^2$$
, et 1 ;

et où $2\sigma_1^2$, $2\sigma_2^2$ sont respectivement la puissance du signal de la source 1, la puissance du signal de la source 2,

et où $2\sigma^2$ est la puissance du bruit supposé gaussien, blanc spatialement, fréquentiellement et temporellement;

et où $M = (U\ V)$.

2. Procédé selon la revendication 1, **caractérisé en ce que** le calcul de l'estimateur de l'espérance conditionnelle est approximé par un traitement appelé « Espérance Conditionnelle à 4 Filtres Linéaires », comportant un traitement de décision à quatre hypothèses portant sur quatre formes hermitiennes de la mesure X , suivi d'un filtrage linéaire commandé par le résultat de la décision, selon les équations :

$$\hat{S} = Q_{j0}M^{*}X \ \text{où} \ j_0 = Arg\ \underset{j}{Max}\left\{\ln\left(q_j \det Q_j \det \Gamma_j\right) + X^{*}MQ_jM^{*}X/2\sigma^2\right\} j \in \{1,2,3,4\}$$

3. Procédé selon l'une des revendications précédentes, **caractérisé en ce qu'**il comporte une étape d'estimation des paramètres $(q_j, \sigma_1^2, \sigma_2^2)$ nécessaires pour établir l'espérance conditionnelle par la méthode des moments opérant sur les cases d'une fenêtre découpée dans la grille temps/fréquence.

4. Procédé selon la revendication 2, **caractérisé en ce que** le calcul de l'estimateur de l' « Espérance Conditionnelle à 4 Filtres Linéaires » est approximé par un traitement appelé « Espérance Conditionnelle à Décisions Indépendantes », obtenu par deux tests statistiques à deux hypothèses, suivi d'un filtrage linéaire commandé par le résultat de la décision.

5. Procédé selon la revendication 4, **caractérisé en ce que** la décision est donnée par :

   o Si $|\hat{s}_{MV}| > seuil$ et $|\hat{c}_{MV}| > seuil$ : les deux sources sont présentes
   ∘ Si $|\hat{s}_{MV}| > seuil$ et $|\hat{c}_{MV}| < seuil$ : la source 1 est présente et la source 2 est absente
   ∘ Si $|\hat{s}_{MV}| < seuil$ et $|\hat{c}_{MV}| > seuil$ : la source 1 est absente et la source 2 est présente
   ∘ Si $|\hat{s}_{MV}| < seuil$ et $|\hat{c}_{MV}| < seuil$ : les deux sources sont absentes

Où $\hat{S}_{MV} = (\hat{s}_{MV}\ \hat{c}_{MV})^T$ est l'estimateur du maximum de vraisemblance bi-sources $\hat{S}_{MV} = (M^{*}M)^{-1} M^{*} X$.

6. Procédé selon les revendications 4 ou 5, **caractérisé en ce que**, en fonction du résultat de la décision, le traitement de filtrage linéaire donnant l'estimateur de l' « Espérance Conditionnelle à Décisions Indépendantes » est $\hat{S}_{ECDI} = (\hat{s}_{ECDI}\ \hat{c}_{ECDI})^T$ :

   o Si les deux sources sont présentes : l'estimateur du maximum de vraisemblance bi-sources pour les signaux s et c : $\hat{S}_{ECDI} = (M^{*} M)^{-1} M^{*} X$
   o Si la source 1 est présente et la source 2 absente : l'estimateur du maximum de vraisemblance mono-source pour $s$ , et 0 pour $c$ : $\hat{S}_{ECDI} = U^{*} X$ , $\hat{c}_{ECDI} = 0$
   o Si la source 1 est absente et la source 2 présente : 0 pour $s$ , et l'estimateur du maximum de vraisemblance mono-source pour $c$ : $\hat{S}_{ECDI} = 0$, $\hat{c}_{ECDI} = V^{*} X$
   o Si les deux sources sont absentes : 0 pour les signaux des deux sources : $\hat{S}_{ECDI} = 0$

7. Procédé selon l'une quelconque des revendications 4 à 6, **caractérisé en ce que** le calcul de l'estimateur de l' « Espérance Conditionnelle à Décisions Indépendantes » est approximé par un traitement appelé « Maximum de Vraisemblance Seuillé » (en abrégé « MVS ») $\hat{S}_{MVS} = (\hat{s}_{MVS}\ \hat{c}_{MVS})^T$ obtenu par l'estimation du ou des signaux par la méthode du maximum de vraisemblance bi-sources suivie de la comparaison de chaque estimation à un seuil, selon les équations :

   ∘

$$\text{Si}\ \left|\hat{s}_{MV}\right| < seuil\ :\ \hat{s}_{MVS} = 0,\ \text{sinon}\ \hat{s}_{MVS} = \hat{s}_{MV}$$

○

$$\text{Si } \left| \hat{c}_{MV} \right| < seuil \,:\, \hat{c}_{MVS} = 0 \,, \text{ sinon } \hat{c}_{MVS} = \hat{c}_{MV}$$

**8.** Procédé selon l'une quelconque des revendications 4 à 7, **caractérisé en ce que** le seuil ou chaque seuil de décision est choisi pour respecter une probabilité dite de fausse alarme consistant à déclarer le signal non nul alors qu'il est nul.

**9.** Procédé selon la revendication 7, **caractérisé en ce qu'**il comporte :

• Une première estimation des signaux réalisée par la méthode de l' »Espérance Conditionnelle à Décisions Indépendantes » ou du « Maximum de Vraisemblance Seuillé »,

• Une estimation de paramètres $\left( q_j, \sigma_1^2, \sigma_2^2 \right)$ réalisée à partir des composantes du signal obtenues l'étape précédente,

• Une seconde estimation des signaux réalisé par la méthode de l'Espérance Conditionnelle ou par la méthode de l' « Espérance Conditionnelle à 4 Filtres Linéaires », informées des valeurs des paramètres $\left( q_j, \sigma_1^2, \sigma_2^2 \right)$ obtenues à l'étape précédente.

**Patentansprüche**

**1.** Verfahren zum Schätzen, durch Recheneinrichtungen, von zwei gemischten Signalen aus verschiedenen Quellen, deren Zeit-/Frequenzdarstellung einen unbekannten Nicht-Null-Anteil von Nullkomponenten erkennen lässt, mittels eines aus P>2 Antennen bestehenden Netzes, wenn die Richtungsvektoren U und *V* der diese Signale aussendenden Quellen bekannt sind oder anderweitig geschätzt werden, umfassend die folgenden Schritte:

a) Berechnen der aufeinanderfolgenden diskreten Fourier-Transformationen des von den Antennen empfangenen und abgetasteten Signals, um ein P-vektorielles Zeit-Frequenz-Gitter des Signals zu erlangen; wobei jedes Element des Gitters als Kästchen bezeichnet wird und einen komplexen Vektor X enthält, der eine Messung bildet;
b) für jedes Feld, Berechnen eines Schätzwerts des Zweiquellensignals S = *(s,c)^T,* wobei s das Signal ist, das mit der ersten Quelle assoziiert ist, und c das Signal ist, das mit der zweiten Quelle assoziiert ist, und (.)^T die Transponierte von (.), S = *(ŝ,ĉ)^T* ist, mittels einer Annäherung des Schätzers des bedingten Erwartungswerts des Signals bzw. der Signale, wobei die Wahrscheinlichkeitsdichte von S als eine Mischung aus zentrierten Gaußschen Zellen modelliert wird, die mit den Koeffizienten $q_1$, $q_2$, $q_3$, $q_4$ der vier möglichen Situationen in jedem Feld gewichtet werden: Vorhandensein beider Quellen, Vorhandensein von Quelle 1 und Nichtvorhandensein von Quelle 2, Nichtvorhandensein von Quelle 1 und Vorhandensein von Quelle 2, Nichtvorhandensein beider Quellen, wobei diese Näherung in folgender Form geschrieben wird:

$$\hat{S} = \frac{\sum_{j=1}^{4} q_j \det Q_j \det \Gamma_j \exp\left( \frac{X^* M Q_j M^* X}{2\sigma^2} \right) Q_j M^* X}{\sum_{j=1}^{4} q_j \det Q_j \det \Gamma_j \exp\left( \frac{X^* M Q_j M^* X}{2\sigma^2} \right)}$$

wobei (.)* den konjugierten Transponierten der Matrix (.) bezeichnet;
und wobei :

$$Q_1 = \frac{1}{\left(1 + \sigma^2 / \sigma_1^2\right)\left(1 + \sigma^2 / \sigma_2^2\right) - \left| U^* V \right|^2} \begin{pmatrix} 1 & -U^* V \\ -V^* U & 1 \end{pmatrix}$$

$$Q_2 = \begin{pmatrix} 1/\left(1+\sigma^2/\sigma_1^2\right) & 0 \\ 0 & 0 \end{pmatrix}$$

$$Q_3 = \begin{pmatrix} 0 & 0 \\ 0 & 1/\left(1+\sigma^2/\sigma_2^2\right) \end{pmatrix}$$

$$Q_4 = \begin{pmatrix} 0 & 0 \\ 0 & 0 \end{pmatrix} ;$$

und wobei det $Q_1$ det $\Gamma_1$, det $Q_2$ det $\Gamma_2$, det $Q_3$ det $\Gamma_3$, det $Q_4$ det $\Gamma_4$ jeweils gleich genommen werden wie:

$(1-|U^*V|^2)^{-1} \sigma^4 / \sigma_1^2\sigma_2^2, \sigma^2 / \sigma_1^2, \sigma^2 / \sigma_2^2$ , und 1;

und wobei $2\sigma_1^2, 2\sigma_2^2$ jeweils die Leistung des Signals von Quelle 1,
die Stärke des Signals von Quelle 2 sind,
und wobei $2\sigma^2$ die Leistung des angenommenen Gaußschen Rauschens ist, das räumlich, frequenzmäßig und zeitlich weiß ist;
und wobei $M =(U\ V)$.

2. Verfahren nach Anspruch 1, **dadurch gekennzeichnet, dass** die Berechnung des Schätzers des bedingten Erwartungswerts durch eine Verarbeitung angenähert wird, die als "bedingte Erwartung mit 4 linearen Filtern" bezeichnet wird und eine Entscheidungsverarbeitung mit vier Hypothesen über vier hermitesche Formen des Maßes X, gefolgt von einer linearen Filterung, die durch das Resultat der Entscheidung gesteuert wird, gemäß den Gleichungen:

$$\hat{S} = Q_{j0}M^*X \quad \text{wo} \quad j_0 = Arg\,\underset{j}{Max}\left\{\ln\left(q_j \det Q_j \det \Gamma_j\right) + X^*MQ_jM^*X/2\sigma^2\right\} j \in \{1,2,3,4\}$$

3. Verfahren nach einem der vorherigen Ansprüche, **dadurch gekennzeichnet, dass** es einen Schritt zum Schätzen der Parameter $(q_j, \sigma_1^2, \sigma_2^2)$ umfasst, die notwendig sind, um den bedingten Erwartungswert durch das Verfahren der Momente zu erstellen, das mit den Kästchen eines Fensters vorgeht, das aus dem Zeit-/Frequenzgitter ausgeschnitten ist.

4. Verfahren nach Anspruch 2, **dadurch gekennzeichnet, dass** die Berechnung des Schätzers für die "bedingte Erwartung mit 4 linearen Filtern" durch eine Verarbeitung angenähert wird, die "bedingte Erwartung mit unabhängigen Entscheidungen" genannt wird und durch zwei statistische Tests mit zwei Hypothesen erlangt wird, gefolgt von einer linearen Filterung, die durch das Resultat der Entscheidung gesteuert wird.

5. Verfahren nach Anspruch 4, **dadurch gekennzeichnet, dass** die Entscheidung gegeben ist durch:

   o Wenn $|\hat{s}_{MV}| > $ *Schwellenwert* und $|\hat{c}_{MV}| > $ *Schwellenwert:* die zwei Quellen sind vorhanden
   o Wenn $|\hat{s}_{MV}| > $ *Schwellenwert* und $|\hat{c}_{MV}| < $ *Schwellenwert:* die Quelle 1 ist vorhanden und die Quelle 2 ist nicht vorhanden
   o Wenn $|\hat{s}_{MV}| < $ *Schwellenwert* und $|\hat{c}_{MV}| > $ *Schwellenwert:* die Quelle 1 ist nicht vorhanden und die Quelle 2 ist vorhanden
   o Wenn $|\hat{s}_{MV}| < $ *Schwellenwert* und $|\hat{c}_{MV}| < $ *Schwellenwert:* die zwei Quellen sind nicht vorhanden

   wobei $\hat{S}_{MV} = (\hat{s}_{MV}\ \hat{c}_{MV})^T$ der Schätzer des Zwei-Quellen-Wahrscheinlichkeitsmaximums $\hat{S}_{MV} = (M^*M)^{-1} M^*X$ *ist.*

6. Verfahren nach Anspruch 4 oder 5, **dadurch gekennzeichnet, dass** abhängig von dem Resultat der Entscheidung die lineare Filterverarbeitung, die den Schätzer für die "bedingte Erwartung mit unabhängigen Entscheidungen"

ergibt, $\hat{S}_{ECDI} = (\hat{s}_{ECDI}\ \hat{c}_{ECDI})^T$ ist:

  o Wenn beide Quellen vorhanden sind: der Zwei-Quellen-Maximum-Wahrscheinlichkeitsschätzer für die Signale $s$ und $c$: $\hat{S}_{ECDI} = (M^*M)^{-1}\ M^*X$
  o Wenn Quelle 1 vorhanden und Quelle 2 nicht vorhanden ist: der Schätzer des Ein-Quellen-Wahrscheinlichkeitsmaximums für $s$, und 0 für c: $\hat{S}_{ECDI} = U^*X,\ \hat{c}_{ECDI} = 0$
  o Wenn Quelle 1 nicht vorhanden ist und Quelle 2 vorhanden ist: 0 für s, und der Ein-Quellen-Wahrscheinlichkeitsmaximum für $c$: $\hat{S}_{ECDI} = 0,\ \hat{c}_{ECDI} = V^*X$
  o Wenn die zwei Quellen nicht vorhanden sind: 0 für die Signale der zwei Quellen: $\hat{S}_{ECDI} = 0$

7. Verfahren nach einem der Ansprüche 4 bis 6, **dadurch gekennzeichnet, dass** die Berechnung des Schätzers der "bedingten Erwartung mit unabhängigen Entscheidungen" durch eine Verarbeitung angenähert wird, die "Wahrscheinlichkeitsmaximum mit Schwellenwert" (abgekürzt "MVS") genannt wird, $\hat{S}_{MVS} = (\hat{s}_{MVS}\ \hat{c}_{MVS})^T$, die durch die Schätzen des Signals oder der Signale durch das Verfahren des Zwei-Quellen-Wahrscheinlichkeitsmaximums gefolgt von dem Vergleich jeder Schätzung mit einem Schwellenwert gemäß den folgenden Gleichungen erlangt wird:

  o

$$\text{Wenn } |\hat{s}_{MV}| < \textit{Schwellenwert}: \hat{s}_{MVS} = 0, \text{ sonst } \hat{s}_{MVS} = \hat{s}_{MV}$$

  o

$$\text{Wenn } |\hat{c}_{MV}| < \textit{Schwellenwert}: \hat{c}_{MVS} = 0, \text{ sonst } \hat{c}_{MVS} = \hat{c}_{MV}$$

8. Verfahren nach einem der Ansprüche 4 bis 7, **dadurch gekennzeichnet, dass** der Schwellenwert oder jeder Entscheidungsschwellenwert gewählt wird, um eine sogenannte Fehlalarmwahrscheinlichkeit einzuhalten, die darin besteht, das Signal für nicht null zu erklären, obwohl es null ist.

9. Verfahren nach Anspruch 7, **dadurch gekennzeichnet, dass**:

  • Eine erste Schätzung der Signale, die mit dem Verfahren der "bedingten Erwartung mit unabhängigen Entscheidungen" oder dem Verfahren des "Wahrscheinlichkeitsmaximum-Schwellenwert" durchgeführt wird,

  • Eine Parameterschätzung $(q_j,\ \sigma_1^2,\ \sigma_2^2)$ aus den im vorherigen Schritt erlangten Signalkomponenten durchgeführt wird,

  • Eine zweite Schätzung der Signale, die durch das Verfahren der bedingten Erwartung oder durch das Verfahren der "bedingten Erwartung mit 4 linearen Filtern" durchgeführt wird, über die Werte der Parameter $(q_j,\ \sigma_1^2,\ \sigma_2^2)$ informiert, die in dem vorherigen Schritt erlangt wurden.

**Claims**

1. A **method** for the non-linear estimation, by calculation means, of two mixed signals from separate sources, the time/frequency representation of which shows an unknown non-zero proportion of zero components, using an array made up of P>2 antennas, when the directional vectors $U$ and $V$ of the sources emitting these signals are additionally known or estimated, including the following steps:

  a) Calculating the successive discrete Fourier transforms of the signal received by the antennas and sampled to obtain a time-frequency P-vector grid of the signal; each element of the grid being referred to as a box and containing a complex vector $X$ forming a measurement;
  b) For each box, calculating an estimation of the dual-source signal $S = (s,c)^T$, s being the signal associated to the first source, and c being the signal associated to the second source, and $(.)^T$ being the transposed of (.), by an approximation of the conditional expectation estimator of the signal, or of the signals, the probability density of S being modeled as a Gaussian mixture centered and weighted by coefficients $q_1$, $q_2$, $q_3$, $q_4$ of the for possible situations in each case among, bothe sources present,: source 1 present and source 2 absent, source 1 absent and source 2 present, both sources absent, said approximation being

$$\hat{S} = \frac{\sum_{j=1}^{k} q_j det\ Q_j \det \Gamma_j \exp\left(\frac{X^* M Q_j M^* X}{2\sigma^2}\right) Q_j M^* X}{\sum_{j=1}^{4} q_j det\ Q_j \det \Gamma_j \exp\left(\frac{X^* M Q_j M^* X}{2\sigma^2}\right)}$$

where (.) * is the conjugated transpose of matrix (.);
and where :

$$Q_1 = \frac{1}{\left(1 + \sigma^2/\sigma_1^2\right)\left(1 + \sigma^2/\sigma_2^2\right) - |U^*V|^2} \begin{pmatrix} 1 & -U^*V \\ -V^*U & 1 \end{pmatrix}$$

$$Q_2 = \begin{pmatrix} 1/\left(1 + \sigma^2/\sigma_1^2\right) & 0 \\ 0 & 0 \end{pmatrix}$$

$$Q_3 = \begin{pmatrix} 0 & 0 \\ 0 & 1/\left(1 + \sigma^2/\sigma_2^2\right) \end{pmatrix}$$

$$Q_4 = \begin{pmatrix} 0 & 0 \\ 0 & 0 \end{pmatrix}$$

**and where** det $Q_1$det $\Gamma_1$, det $Q_2$det $\Gamma_2$, det $Q_3$det $\Gamma_3$, det $Q_4$det $\Gamma_4$ are chosen

respectively equal to: $\left(1 - |U^*V|^2\right)^{-1} \sigma^4/\sigma_1^2\sigma_2^2,\ \sigma^2/\sigma_1^2,\ \sigma^2/\sigma_2^2$, and 1 ;

and where $2\sigma_1^2,\ 2\sigma_2^2$ and respectively the power of the signal from source 1, the power of the signal from source 2,

and where $2\sigma^2$ is the power of the noise supposed Gaussian, spatially, frequentially and temporally white;
and where $M = (U\ V)$.

2. The method according to claim 1, **characterized in that** the calculation of the conditional expectation estimator is approximated by a Conditional Expectation with 4 Linear Filters obtained by a four-hypothesis decision processing pertaining to four Hermitian forms of the measurement $X$, followed by linear filtering commanded by the result of the decision: according to equations :

$$\hat{S} = Q_{j_0} M^* X \text{ where } j_0 = Arg\max_{j}\left\{\ln\left(q_j\det Q_j\det\Gamma_j\right) + X^* M Q_j M^* X/2\sigma^2\right\},\ j \in \{1,2,3,4\}$$

3. **The** method according to any of the preceding claims, **characterized in that** it includes a step for estimating

parameters $(q_j, \sigma_1^2, \sigma_2^2)$ necessary to establish the conditional expectation using the method of moments operating on the boxes of a divided window in the time/frequency grid.

4. The method according to claim 2, **characterized in that** the calculation of the Conditional Expectation estimator with 4 Linear Filters is approximated by a treatment named "Conditional Expectation with Independent Decisions" obtained by two statistics tests with two-hypothesis, followed by linear filtering commanded by the result of the decision.

5. The method according to claim 4, **characterized in that** the decision is given by:

- if $|\hat{s}_{MV}| > threshold$ and $|\hat{c}_{MV}| > threshold$ : both sources are presents,

- if $|\hat{s}_{MV}| >$ *threshold* and $|\hat{c}_{MV}| <$ *threshold* : source 1 is present and source 2 is absent,
- if $|\hat{s}_{MV}| <$ *threshold* and $|\hat{c}_{MV}| >$ *threshold* : source 1 is absent and source 2 is present,
- if $|\hat{s}_{MV}| <$ *threshold* and $|\hat{c}_{MV}| <$ *threshold* : both sources are absents,

where

$$\hat{S}_{MV} = (M^*M)^{-1}M^*X.$$

6.  The method according to claims 4 or 5, **characterized in that**, as a function of the result of the decision, the linear filtering processing yielding the "Conditional Expectation estimator with Independent Decisions" is $\hat{S}_{ECDI} = (\hat{s}_{ECDI} \ \hat{c}_{ECDI})^T$:

    - is both sources are presents: the estimator of the dual-source maximum likelihood for the signal s and c: $\hat{S}_{ECDI} = (M^*M)^{-1}M^*X$,
    - if source 1 is present and source 2 is absent: the single-source maximum likelihood estimator for s and, 0 for c: $\hat{S}_{ECDI} = U^*X$, $\hat{c}_{ECDI} = 0$,
    - if source 1 is absent and source 2 is present: 0 for s, and the single-source maximum likelihood estimator for c,: $\hat{S}_{ECDI} = 0$, $\hat{c}_{ECDI} = V^*X$,
    - is both sources are absents: 0 for the signals of the two sources : $\hat{S}_{ECDI} = 0$,

7.  The method according to any of claims 4 to 6, **characterized in that** the calculation of the Conditional Expectation estimator with 4 Linear Filters is approximated by a treatment named Thresholded Maximum Likelihood, $\hat{S}_{MVS} = (\hat{s}_{MVS} \ \hat{c}_{MVS})^T$ obtained by estimating the signal(s) by the dual-sources maximum likelihood method followed by the comparison of each estimate to a threshold, according to equations:

    -

    $$\text{if } \left|\hat{s}_{MV}\right| < threshold\text{: } \hat{s}_{MVS} = 0, \text{ else } \hat{s}_{MVS} = \hat{s}_{MV}$$

    -

    $$\text{if } \left|\hat{c}_{MV}\right| < threshold\text{: } \hat{c}_{MVS} = 0, \text{ else } \hat{c}_{MVS} = \hat{c}_{MV}$$

8.  **The** method according to any of claims 4 to 7, **characterized in that** the or each decision threshold is chosen to respect a so-called false alarm likelihood consisting of declaring the signal to be non-zero when it is zero.

9.  The method according to claim 7, **characterized in that** it includes:

    • A first estimate of the signals done using the Conditional Expectation with Independent Decisions or Thresholded Maximum Likelihood method,
    • An estimate of parameters $(q_j, \sigma_1^2, \sigma_2^2)$ done from the components of the signal obtained in the previous step,
    • A second estimate of the signals done using the "Conditional Expectation method or the Conditional Expectation with 4 Linear Filters" method, informed of the values of the parameters $(q_j, \sigma_1^2, \sigma_2^2)$ obtained in the previous step.

## FIG.1

M=U                 Mesure X

$$210 \quad \hat{s}_{MV} = U^* X$$

$$350 \quad \left| \hat{s}_{MV} \right| > ou < seuil?$$

$$362 \quad \hat{s}_{ECDI} = 0 \qquad \hat{s}_{ECDI} = \hat{s}_{MV} \quad 361$$

## FIG.2

M=(U,V)              Mesure X

$$220 \quad \hat{S}_{MV} = \begin{pmatrix} \hat{s}_{MV} \\ \hat{c}_{MV} \end{pmatrix} = (M^* M)^{-1} M^* X$$

$$320 \quad \left| \hat{s}_{MV} \right| > ou < seuil? \qquad \left| \hat{c}_{MV} \right| > ou < seuil?$$

$$\left| \hat{s}_{MV} \right| < seuil \qquad \left| \hat{s}_{MV} \right| < seuil \qquad \left| \hat{s}_{MV} \right| > seuil \qquad \left| \hat{s}_{MV} \right| > seuil$$
$$\left| \hat{c}_{MV} \right| < seuil \qquad \left| \hat{c}_{MV} \right| > seuil \qquad \left| \hat{c}_{MV} \right| < seuil \qquad \left| \hat{c}_{MV} \right| > seuil$$

$$\hat{s}_{ECDI} = 0 \qquad \hat{s}_{ECDI} = 0 \qquad \hat{s}_{ECDI} = U^* X \qquad \hat{s}_{ECDI} = \hat{s}_{MV}$$
$$\hat{c}_{ECDI} = 0 \qquad \hat{c}_{ECDI} = V^* X \qquad \hat{c}_{ECDI} = 0 \qquad \hat{c}_{ECDI} = \hat{c}_{MV}$$

334            333            332            331

## FIG.3

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- **MASTER A S**. Bayesian two source modeling for separation of n soucres from stereo signals. *ACOUSTICS, SPEECH, AND SIGNAL PROCESSING*, 2004

- Robust Adaptive Beamforming. Wiley, 2006